# EUROPEAN PATENT SPECIFICATION

(11) **EP 1 633 015 B1**
(45) Date of publication and mention of the grant of the patent: **14.05.2008**
(21) Application number: 05018907.5
(22) Date of filing: 31.08.2005
(51) Int. Cl.: H01Q 1/42, H05K 9/00, H05K 5/06

(54) **Sealing member and sealing structure of electronic circuit unit**
Abdichtelement und Dichtungsanordnung für elektronische Schaltung
Elément d'étanchéité et dispositif d'étanchéité pour unité de circuit électronique

(30) Priority: 01.09.2004 JP 2004254246
(43) Date of publication of application: 08.03.2006
(73) Proprietor: ALPS ELECTRIC CO., LTD., Tokyo 145-8501 (JP)
(72) Inventor: Sasaki, Kazuhiro, c/o Alps Electric Co., Ltd., Ota-ku, Tokyo 145-9501 (JP); Murakami, Jun, c/o Nippon Valqua Industries, Ltd., Shinjuku-ku, Tokyo (JP); Nakajima, Terumasa, c/o K.K. Valqua Elastomer, Higashishirakawa-gun, Fukushima-ken (JP)
(74) Representative: Klunker . Schmitt-Nilson . Hirsch

(56) References cited:
- EP-A- 1 033 779
- EP-A- 1 253 665
- US-A- 5 625 365
- US-A- 5 670 745
- PATENT ABSTRACTS OF JAPAN vol. 1999, no. 01, 29 January 1999 (1999-01-29) & JP 10 276020 A (MITSUMI ELECTRIC CO LTD), 13 October 1998 (1998-10-13)

## Description

### BACKGROUND OF THE INVENTION

### 1. Field of the Invention

The present invention relates to a sealing member according to the preamble of claim 1. It also relates to a sealing structure having such sealing member.

### 2. Description of the Related Art

In electronic circuit units, such as an antenna device having a low-noise amplifier circuit and an antenna element which are unitized with the antenna device, within a casing formed by fitting a pair of cases to each other, an electronic circuit, such as a circuit board, is accommodated, and a signal cable connected to the electronic circuit may be drawn out therefrom via a cable socket arranged adjacent to the fitting portion between the pair of cases. Thus, in order to secure dust-proof and water-proof of such an electronic circuit unit, a sealing member is required for sealing gaps generated in a fitting portion between a pair of cases and the cable socket.

As a sealing structure of such an electronic circuit unit, a technique has been generally adopted to use a first sealing member according to the preamble of claim 1, such as an O-ring, mounted on the fitting portion all round and a second sealing member armored at a predetermined position of a signal cable so as to be mounted in the cable socket in combination (see Japanese Unexamined Patent Application Publication No. 10-276020 (p 2, Fig. 13)).

However, in an assemble process of the electronic circuit unit adopting the sealing structure using the first sealing member with the second sealing member described above, before fitting the pair of cases to each other, it is necessary to arrange the first sealing member in the fitting portion and to armor the second sealing member at a predetermined position of the signal cable so as to be arranged in the cable socket. These two sealing members must be separately handled, so that assembling the sealing members has been complicated. Also, in the conventional sealing structure, there has been a problem that a reliable sealing structure is difficult to be achieved because a gap may be produced between the first and second sealing members.

### SUMMARY OF THE INVENTION

The present invention has been made in view of such situations of conventional techniques, and it is a first object thereof to provide a sealing member that is easily assembled and has a high sealing effect in a cable socket. Also it is a second object of the present invention to provide a sealing structure of an electronic circuit unit with a high sealing effect in the cable socket and having a sealing member that is easily assembled.

In order to achieve the first object mentioned above, a sealing member made of an elastic molding according to the present invention includes the features of claim 1.

Because the annular circumferential mounting portion to be mounted in the fitting portion between the pair of cases is formed integrally with the cable insertion portion to be mounted to the cable socket, the sealing member constructed as described above can be easily assembled in comparison with a case where different two sealing members are separately assembled. Since no gap is produced between the circumferential mounting portion and the cable insertion portion, the sealing in the cable socket is also effective. Moreover, in a no-load state of the sealing member, the axial direction of the insertion hole substantially corresponds to that of the circumferential mounting portion, so that a slide core can be eliminated and the sealing member is manufactured at low cost with a simple metallic mold.

During assembling the sealing member constructed as described above in sealing portions, it is preferable that the cable insertion portion in a state elastically rotated by about 90° on the plane be mounted into the cable socket, so that the axial direction of the insertion hole be established to be substantially perpendicular to that of the circumferential mounting portion. Thereby, the extending direction of the signal cable in the cable socket can be established to be substantially perpendicular to the height direction of the casing, so that the coaxial cable is easily routed.

In order to achieve the second object mentioned above, a sealing structure of an electronic circuit unit according to the present invention includes the features of claim 3.

Using the sealing member having the circumferential mounting portion molded integrally with the cable insertion portion in such a manner enables clearances generated in the fitting portion between the pair of cases and generated in the cable socket to be sealed together, so that the sealing member can be easily assembled, improving assembling efficiency of the electronic circuit unit. Since no gap is produced between the circumferential mounting portion and the cable insertion portion, the sealing in the cable socket is effective, achieving a reliable sealing structure. Moreover, since the axial direction of the insertion hole of the sealing member is established to be substantially perpendicular to that of the circumferential mounting portion, the extending direction of the signal cable in the cable socket can be established to be substantially perpendicular to the height direction of the casing, so that the coaxial cable is easily routed.

In such a sealing structure of an electronic circuit unit, in the sealing member before being mounted in the fitting portion and the cable socket, the cable insertion portion is rotatable on a plane substantially perpendicular to an extending direction of the part of the circumferential mounting portion adjacent to the cable insertion portion while the axial direction of the insertion hole substantially corresponds to that of the circumferential mounting portion, and it is preferable that the cable insertion portion in a state elastically rotated by about 90° on the plane be mounted into the cable socket, so that the axial direction of the insertion hole be established to be substantially perpendicular to that of the circumferential mounting portion. Thereby, a slide core can be eliminated, so that the sealing member is manufactured at low cost with a simple metallic mold.

### BRIEF DESCRIPTION OF THE DRAWINGS

Fig. 1 is a sectional view showing the entire structure of an antenna device according to an embodiment of the present invention;
Fig. 2 is a perspective view of the antenna device viewed from the bottom surface;
Fig. 3 is a perspective view of the antenna device showing a state of Fig. 2 from which a reflection plate is removed;
Fig. 4 is a perspective view of a sealing member to be assembled in the antenna device;
Fig. 5 is a perspective view of the body of the antenna device;
Fig. 6 is an exploded perspective view of the body;
Fig. 7 is a sectional view of the body at the line A-A of Fig. 5; and
Fig. 8 is an enlarged view of B region of Fig. 5.

### DESCRIPTION OF THE PREFERRED EMBODIMENTS

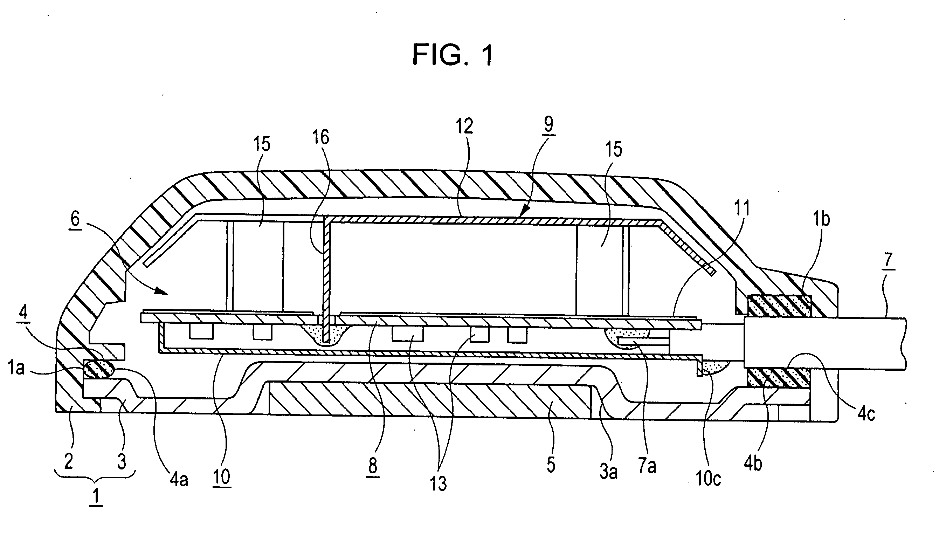

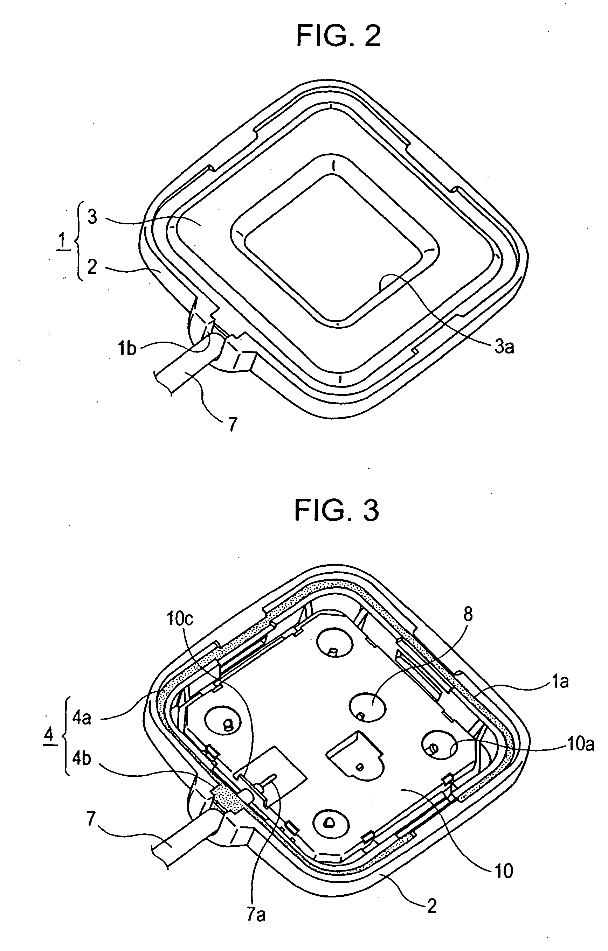

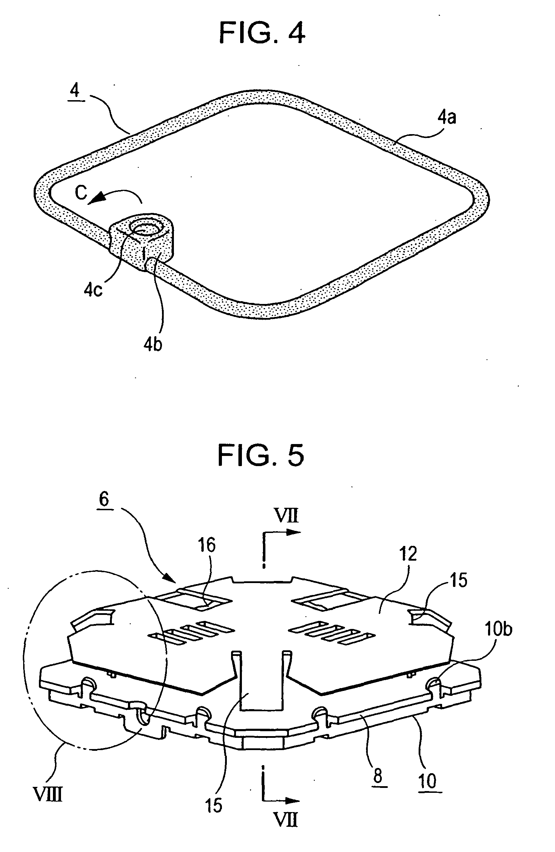

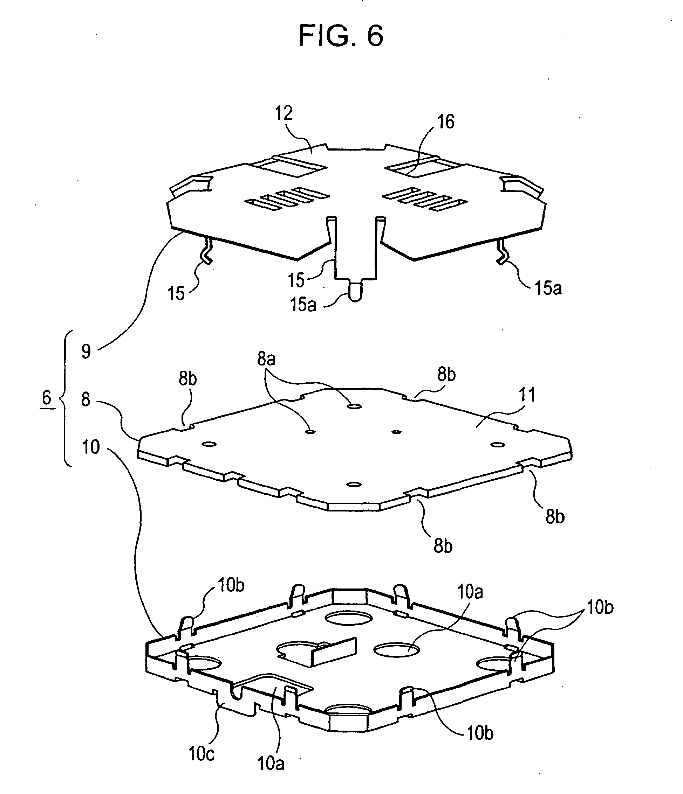

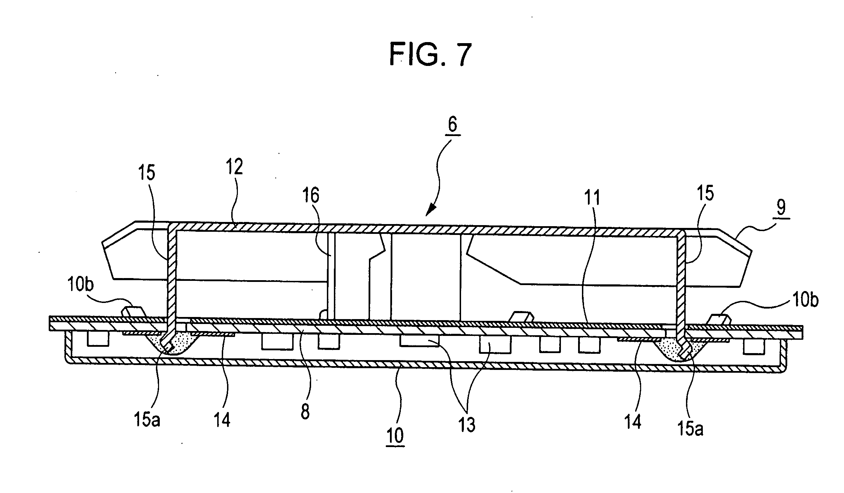

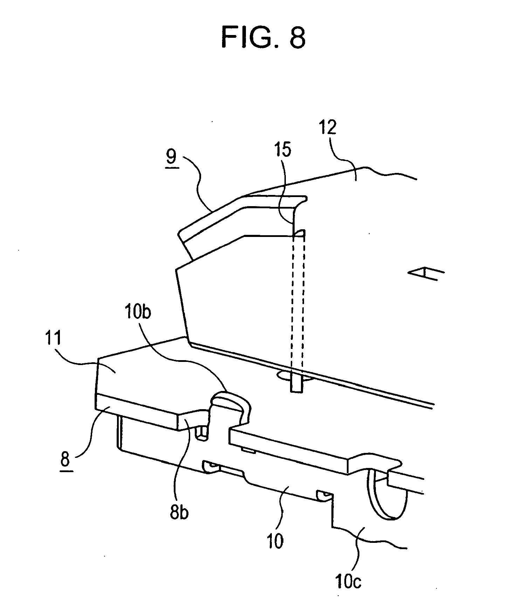

Embodiments of the present invention will be described with reference to the drawings. Fig. 1 is a sectional view of the entire structure of an antenna device (antenna unit) according to an embodiment of the present invention; Fig. 2 is a perspective view of the antenna device viewed from the bottom side; Fig. 3 is a perspective view of a state in that a reflection plate is removed from Fig. 2; Fig. 4 is perspective view of a sealing member to be assembled to the antenna device; Fig. 5 is a perspective view showing a body of the antenna device; Fig. 6 is an exploded and perspective of the body; Fig. 7 is a sectional view of the body at the line A-A of Fig. 5; and Fig. 8 is an enlarged view of region B of Fig. 5.

The antenna device shown in these figures mainly includes a casing 1 formed by fitting a radome 2 which is an upper case to a reflection plate 3 which is a lower case, a sealing member 4 mounted in a fitting portion between the radome 2 and the reflection plate 3, a magnet 5 attached on the bottom surface of the reflection plate 3, a body 6 accommodated within an interior space of the casing 1, and a coaxial cable 7 for electrically connecting the body 6 to an external circuit (a receiving circuit) (not shown). The body 6 includes a circuit board 8 having an electronic circuit such as a low-noise amplifier circuit, an antenna element 9 that is a sheet plate patch antenna, and a metallic plate shielding case 10 (see Fig. 6). A ground pattern 11 arranged on the substantially entire surface of the circuit board 8 opposes a conductor plate 12 of the antenna element 9 with a predetermined space therebetween. On the bottom surface of the circuit board 8, a wiring pattern (not shown) is arranged while various electronic components 13 connected to the wiring pattern are mounted, so that the electronic components 13 and the wiring pattern constitute the electronic circuit.

The radome 2 is a synthetic resin molding and has a lower opening so as to cover the body 6. The reflection plate 3 is formed by pressing a metallic plate and covers the lower opening of the radome 2. The reflection plate 3 is provided with a recess 3a formed at the center of the bottom surface, and within the recess 3a, the magnet 5 is fixed (however, the magnet 5 is omitted in Fig. 2). In addition, the reflection plate 3 is established in size to be slightly larger than the conductor plate 12 of the antenna element 9. The casing 1 is assembled by fitting the radome 2 to the reflection plate 3, and between the radome 2 and the reflection plate 3, a substantially rectangular fitting portion 1a and a cable socket 1b adjacent to the fitting portion 1a are formed. As shown in Fig. 3, an annular circumferential mounting portion 4a of the sealing member 4 is mounted on the fitting portion 1a, and a cable insertion portion 4b of the sealing member 4 is mounted on a cable socket 1b, so that gaps existing in the fitting portion 1a and the cable socket 1b are sealed.

The sealing member 4 is a molding made of an elastic material, such as an elastomer, and in a state of a single article before being assembled with the casing 1 (a no-load state), it has a shape shown in Fig. 4, which is molded of the annular circumferential mounting portion 4a integrally with the cable insertion portion 4b. That is, the annular circumferential mounting portion 4a is substantially rectangular frame-shaped similarly to the fitting portion 1a in shape. The cable insertion portion 4b is a convex object with an external shape fitting the cable socket 1b and having an insertion hole 4c formed therein. The axial direction of the insertion hole 4c corresponds to the axial direction of the annular circumferential mounting portion 4a. Since the annular circumferential mounting portion 4a is continuously connected to corners of the cable insertion portion 4b, the cable insertion portion 4b, as shown in arrow C of Fig. 4, is rotatable on a plane substantially perpendicular to the extending direction of the part adjacent to the cable insertion portion 4b of the annular circumferential mounting portion 4a. The insertion hole 4c of the cable insertion portion 4b is for inserting the coaxial cable 7 therethrough. When the sealing member 4 is assembled in the casing 1, after the coaxial cable 7 is inserted into the insertion hole 4c and the cable insertion portion 4b is mounted into the cable socket 1b in a state of the cable insertion portion 4b elastically rotated by about 90° in arrow C direction, the annular circumferential mounting portion 4a is mounted in the fitting portion 1a. Thereby, as shown in Fig. 3, the axial direction of the insertion hole 4c can be established to be substantially perpendicular to the axial direction of the annular circumferential mounting portion 4a (the height direction of the casing 1), so that the coaxial cable 7 is easily routed.

The body 6 of the antenna device will be described. The wiring pattern formed on the bottom surface of the circuit board 8 is provided with a central conductor 7a of the coaxial cable 7 soldered thereon, and on the bottom surface of the circuit board 8, four solder lands 14 (see Fig. 7) are provided electrically independently from the wiring pattern. Furthermore, as shown in Fig. 6, the circuit board 8 is provided with a plurality of through holes 8a formed at positions including those corresponding to the solder lands 14 as well as a plurality of concave notches 8b formed in the periphery.

The antenna element 9 includes the radiation conductor plate 12 opposing the ground pattern 11 with an air layer therebetween, four mounting legs 15 formed by cutting up the radiation conductor plate 12 except its center toward the circuit board 8, and two power-feeding pieces 16 formed by cutting up the radiation conductor plate 12 adjacent to its center toward the circuit board 8. The four mounting legs 15 and the two power-feeding pieces 16 are inserted into the corresponding through-holes 8a and soldered on the bottom surface of the circuit board 8. The mounting legs 15 are connected to the solder lands 14 while the power-feeding pieces 16 are connected to the wiring pattern. As shown in Fig. 7, at the end of the mounting leg 15, an elastic hook 15a is formed, and by pressing the elastic hook 15a, the mounting leg 15 is retained to the circuit board 8. Hence, by pressing the mounting legs 15 into the corresponding through-holes 8a, the antenna element 9 can be temporarily fixed to the circuit board 8 simply and precisely. The antenna element 9 is finally fixed to the circuit board 8 by soldering the thus self-sustained antenna device 9 in a reflow furnace.

The shielding case 10 covers the electronic components 13 of the low-noise amplifier circuit, so that antenna characteristic deterioration by undesired electric waves radiated from the low-noise amplifier circuit is reduced as well as possibilities of bad influence on the low-noise amplifier circuit from external interfering waves are reduced to a large extent, securing high reliability. The shielding case 10 is provided with a plurality of get-away holes 10a formed at positions opposing soldering portions on the bottom surface of the circuit board 8. In the periphery of the shielding case 10, a plurality of elastic retainers 10b are upward protruded, which are soldered to the ground pattern 11 on the top surface of the circuit board 8 after being snap-fitted into the corresponding notches 8b of the circuit board 8. In this case, also by snap-fitting the elastic retainers 10b into the corresponding notches 8b, the shielding case 10 can be temporarily fixed to the circuit board 8 simply and precisely, so as to be finally fixed to the circuit board 8 by soldering the thus self-sustained shielding case 10 in a reflow furnace. At a predetermined position of the periphery of the shielding case 10, a substantially U-shaped cable holding portion 10c is formed by cutting down therefrom so as to position the end portion of the coaxial cable 7 (see Fig. 3).

The antenna device constructed as described above can be operated as a circular polarized antenna by two-point feeding power to the radiation conductor plate 12 via the two power-feeding pieces 16 connected to the wiring pattern of the circuit board 8. That is, when a predetermined highfrequency signal is fed to the radiation conductor plate 12 via the low-noise amplifier circuit, circular polarized radio waves are radiated from the radiation conductor plate 12, and when the signal radio waves are received by the radiation conductor plate 12, the electric signal is outputted to external receiver circuits via the low-noise amplifier circuit and the coaxial cable 7.

In the antenna device according to the embodiment, the body 6 including the circuit board 8 and the radiation conductor plate 12 is accommodated within the casing 1 as well as the sealing member 4 is mounted in the fitting portion 1a and the cable socket 1b of the casing 1, enabling dust proof and water proof to be secured. Moreover, the sealing member 4 can be easily assembled in comparison with a case where different two sealing members are separately assembled, because the annular circumferential mounting portion 4a of the sealing member 4 to be mounted in the fitting portion 1a is formed integrally with the cable insertion portion 4b to be mounted to the cable socket 1b. Furthermore, since no gap is produced between the annular circumferential mounting portion 4a and the cable insertion portion 4b, the sealing in the cable socket 1b is also effective. Therefore, by adopting such a sealing structure, reduction in assembling cost and improvement in dust/water proof may be promised. Also, because in the sealing member 4 in a no-load state, the axial direction of the insertion hole 4c corresponds to the axial direction of the annular circumferential mounting portion 4a, a slide core can be eliminated by directing the die opening in this axial direction, so that the sealing member 4 is manufactured at low cost with a simple metallic mold. Moreover, during assembling the sealing member 4 in the casing 1, by mounting the cable insertion portion 4b into the cable socket 1b in an elastically rotated state, the axial direction of the insertion hole 4c can be established to be substantially perpendicular to the axial direction (the height direction of the casing 1) of the annular circumferential mounting portion 4a, so that the coaxial cable 7 can be easily routed.

In the antenna device according to the embodiment, since the solder land 14, on which the mounting leg 15 of the radiation conductor plate 12 is soldered, opposes the ground pattern 11 with the circuit board 8 therebetween, an additional capacitance is generated between the solder land 14 and the ground pattern 11, so that the resonance frequency is reduced, enabling the antenna element 9 to be miniaturized. Because the resonance frequency is varied in accordance with sizes and the arrangement of a plurality of solder lands 14, the resonance frequency can be comparatively easily micro-adjusted and broadened. Furthermore, the antenna device uses the metallic reflection plate 3 as the lower case, so that by reflecting radio waves with the reflection plate 3, the radiations in undesired directions are suppressed, increasing gain. Moreover, since the magnet 5 is fixed within the recess 3a on the bottom surface of the reflection plate 3, the antenna device can be easily attached to arbitrary positions in both the outside and inside vehicle cabin where a metal is embedded or exposed.

In the antenna device according to the embodiment, the antenna element 9 before the soldering process can be self-sustained on the circuit board 8 by pressing the elastic hook 15a of the mounting leg 15 into the through-hole 8a while the shielding case 10 before the soldering process can be self-sustained on the circuit board 8 by snap-fitting the elastic retainers 10b into the notches 8b, so that the antenna element 9 and the shielding case 10 can be reflow-soldered together. That is, in the assemble process of the antenna device, after cream solder is applied to predetermined positions of the circuit board 8, at which the mounting legs 15 and the power-feeding pieces 16 are soldered, the antenna element 9 and the shielding case 10 are attached on the circuit board 8; at this time, since the antenna element 9 is temporarily fixed by the retaining of the elastic hook 15a, the antenna element 9 and the shielding case 10 can be reflow-soldered together in a self-sustained state on the circuit board 8. Doing so enables the number of processes to be reduced in comparison with a case where the antenna element 9 and the shielding case 10 are separately reflow-soldered, reducing assembling cost to a large extent. Also, in the antenna device, because the antenna element 9 is a sheet-metal patch antenna, the component cost can be obviously reduced less than that of a dielectric antenna.

In addition, according to the embodiment, the sealing structure of the antenna device (antenna unit) has been described; alternatively, other electronic circuit units having signal cables, such as a lead-out coaxial cable, may also have the same advantages as those of the embodiment by using a sealing member made by integrally molding an annular circumferential mounting portion of the sealing member to be mounted in a fitting portion with a cable insertion portion thereof to be mounted to a cable socket.

## Claims

1. A sealing member (4) made of an elastic molding comprising:
an annular circumferential mounting portion (4a) to be mounted in a fitting portion (1a) between a pair of cases (2,3) constituting a casing (1); and
a cable insertion portion (4b) having an insertion hole (4c) to be mounted in a cable socket (1b) of the casing (1) adjacent to the fitting portion (1a), **characterized in that** the cable insertion portion is formed integrally with the circumferential mounting portion (4a),
that the cable insertion portion (4b) is rotatable on a plane substantially perpendicular to an extending direction of the part of the circumferential mounting portion (4a) adjacent to the cable insertion portion (4b), and
that in a no-load state, the axial direction of the insertion hole (4c) substantially corresponds to that of the circumferential mounting portion (4a).

2. The member according to Claim 1, wherein the cable insertion portion (4b) in an elastically rotated state by about 90° on the plane is mounted into the cable socket (1b), so that the axial direction of the insertion hole (4c) is established to be substantially perpendicular to that of the circumferential mounting portion (4a).

3. A sealing structure of an electronic circuit unit comprising the sealing member (4) according to Claim 1, wherein
an electronic circuit (8) is accommodated within the interior space of the casing (1);
a signal cable (7) is connected to the electronic circuit (8) and being outside taken through the cable socket (1b).

4. The structure according to Claim 3, wherein in the sealing member (4) before being mounted in the fitting portion (1a) and the cable socket (1b), the cable insertion portion (4b) is rotatable on a plane substantially perpendicular to an extending direction of the part of the circumferential mounting portion (4a) adjacent to the cable insertion portion (4b) while the axial direction of the insertion hole (4c) substantially corresponds to that of the circumferential mounting portion (4a), and
wherein the cable insertion portion (4b) in a state elastically rotated by about 90° on the plane is mounted into the cable socket (1b), so that the axial direction of the insertion hole (4c) is established to be substantially perpendicular to that of the circumferential mounting portion (4a).

## Patentansprüche

1. Dichtungselement (4), das aus einem elastischen Formteil gebildet ist und Folgendes aufweist:
einen ringförmigen, umfangsmäßig umlaufenden Befestigungsbereich (4a) zur Befestigung in einem Einpassbereich (1a) zwischen einem Paar von Gehäuseteilen (2, 3), die ein Gehäuse (1) bilden; und
einen Kabeleinführbereich (4b), der eine Einführöffnung (4c) aufweist und in einer an den Einpassbereich (1a) angrenzenden Kabelaufnahme (1 b) des Gehäuses (1) anzubringen ist,
**dadurch gekennzeichnet, dass** der Kabeleinführbereich in integraler Weise mit dem umfangsmäßig umlaufenden Befestigungsbereich (4a) ausgebildet ist,
dass der Kabeleinführbereich (4b) in einer Ebene drehbar ist, die im Wesentlichen rechtwinklig zu der Erstreckungsrichtung des dem Kabeleinführbereich (4b) benachbarten Teils des umfangsmäßig umlaufenden Befestigungsbereichs (4a) ist, und
dass in einem unbelasteten Zustand die Axialrichtung der Einführöffnung (4c) im Wesentlichen der Axialrichtung des umfangsmäßig umlaufenden Befestigungsbereichs (4a) entspricht.

2. Element nach Anspruch 1,
wobei der Kabeleinführbereich (4b) in einem elastisch verdrehten Zustand, in dem er um etwa 90° zu der Ebene verdreht ist, in der Kabelaufnahme (1 b) derart angebracht ist, dass die Axialrichtung der Einführöffnung (4c) im Wesentlichen rechtwinklig zu der Axialrichtung des umfangsmäßig umlaufenden Befestigungsbereichs (4a) ist.

3. Dichtungskonstruktion einer elektronischen Schaltungseinheit, die das Dichtungselement (4) gemäß Anspruch 1 aufweist,
wobei eine elektronische Schaltung (8) im Innenraum des Gehäuses (1) untergebracht ist;
wobei ein Signalkabel (7) mit der elektronischen Schaltung (8) verbunden ist und durch die Kabelaufnahme (1 b) nach außen geführt ist.

4. Konstruktion nach Anspruch 3,
wobei bei dem Dichtungselement (4) vor dessen Anbringung in dem Einpassbereich (1a) und der Kabelaufnahme (1 b) der Kabeleinführbereich (4b) in einer Ebene drehbar ist, die im Wesentlichen rechtwinklig zu der Erstreckungsrichtung des dem Kabeleinführbereich (4b) benachbarten Teils des umfangsmäßig umlaufenden Befestigungsbereichs (4a) ist, während die Axialrichtung der Einführöffnung (4c) im Wesentlichen der Axialrichtung des umfangsmäßig umlaufenden Befestigungsbereichs (4a) entspricht, und
wobei der Kabeleinführbereich (4b) in einem elastisch verdrehten Zustand, in dem er um etwa 90° zu der Ebene verdreht ist, in der Kabelaufnahme (1 b) derart angebracht ist, dass die Axialrichtung der Einführöffnung (4c) im Wesentlichen rechtwinklig zu der Axialrichtung des umfangsmäßig umlaufenden Befestigungsbereichs (4a) ist.

## Revendications

1. Élément d'étanchéité (4) fait d'un moulage élastique comprenant :
une portion de montage annulaire circonférentielle (4a) destinée à être montée dans une portion d'ajustement (1a) entre deux coques (2, 3) constituant un boîtier (1) ; et
une portion d'insertion de câble (4b) comportant un trou d'insertion (4c), destinée à être montée dans une douille de câble (1b) du boîtier (1) à côté de la portion d'ajustement (1a),
**caractérisé en ce que** la portion d'insertion de câble est formée d'un seul tenant avec la portion de montage circonférentielle (4a)
**en ce que** la portion d'insertion de câble (4b) peut tourner dans un plan sensiblement perpendiculaire à la direction d'extension de la partie de la portion de montage circonférentielle (4a) adjacente à la portion d'insertion de câble (4b), et
**en ce que** dans un état non chargé, la direction axiale du trou d'insertion (4c) correspond sensiblement à celle de la portion de montage circonférentielle (4a).

2. Élément selon la revendication 1, dans lequel la portion d'insertion de câble (4b) est montée dans la douille de câble (1b) dans un état de rotation élastique d'environ 90° dans le plan, de sorte que la direction axiale du trou d'insertion (4c) est déterminée de manière à être sensiblement perpendiculaire à celle de la portion de montage circonférentielle (4a).

3. Dispositif d'étanchéité d'une unité de circuit électronique comprenant l'élément d'étanchéité (4) selon la revendication 1, dans lequel
un circuit électronique (8) est reçu dans l'espace intérieur du boîtier (1) ;
un câble de signal (7) est connecté au circuit électronique (8) et sort vers l'extérieur à travers la douille de câble (1b).

4. Dispositif selon la revendication 3, dans lequel, dans l'élément d'étanchéité (4), avant d'être montée dans la portion d'ajustement (1a) et la douille de câble (1b), la portion d'insertion de câble (4b) peut tourner dans un plan sensiblement perpendiculaire à la direction d'extension de la partie de la portion de montage circonférentielle (4a) adjacente à la portion d'insertion de câble (4b), tandis que la direction axiale du trou d'insertion (4c) correspond sensiblement à celle de la portion de montage circonférentielle (4a), et
dans lequel la portion d'insertion de câble (4b) est montée dans la douille de câble (1b) dans un état de rotation élastique d'environ 90° dans le plan, de sorte que la direction axiale du trou d'insertion (4c) est déterminée de manière à être sensiblement perpendiculaire à celle de la portion de montage circonférentielle (4a).
